# FASCICULE DE BREVET EUROPEEN

(11) **EP 2 521 638 B1**
(45) Date de publication et mention de la délivrance du brevet: **16.03.2016**
(21) Numéro de dépôt: 10809156.2
(22) Date de dépôt: 22.12.2010
(51) Int. Cl.: B26F 1/26, H01L 21/768

(54) **PROCEDE DE REALISATION DE TROUS A L'AIDE D'UN JET DE FLUIDE**
VERFAHREN ZUR HERSTELLUNG VON LÖCHERN MIT EINEM FLÜSSIGKEITSSTRAHL
METHOD FOR MAKING HOLES USING A FLUID JET

(30) Priorité: 04.01.2010 FR 1000006
(43) Date de publication de la demande: 14.11.2012
(73) Titulaire: Commissariat à l'Énergie Atomique et aux Énergies Alternatives, 75015 Paris (FR)
(72) Inventeur: BENWADIH, Mohamed, F-94500 Champigny-sur-Marne (FR); HEITZMANN, Marie, F-38650 Sinard (FR)
(74) Mandataire: Talbot, Alexandre
(86) Numéro de dépôt international: PCT/FR2010/000865
(87) Numéro de publication internationale: WO 2011/080419

(56) Documents cités:
- US-A1- 2006 024 859
- US-B1- 6 403 397
- KAWASE T ET AL: "INKJET PRINTED VIA-HOLE INTERCONNECTIONS AND RESISTORS FOR ALL-POLYMER TRANSISTOR CIRCUITS", ADVANCED MATERIALS, WILEY VCH VERLAG, DE LNKD- DOI:10.1002/1521-4095(200111)13:21&LT,1601 ::AID-ADMA1601&GT,3.0.CO,2-X, vol. 13, no. 21, 2 novembre 2001 (2001-11-02), pages 1601-1605, XP001129628, ISSN: 0935-9648 cité dans la demande

## Description

### Domaine technique de l'invention

L'invention concerne un procédé de réalisation d'un trou dans une couche. En particulier, l'invention concerne la réalisation de vias d'interconnexion dans les dispositifs réalisés en matériaux organiques.

### État de la technique

L'augmentation continue des performances des circuits intégrés, par exemple en termes de consommation et/ou de fréquence de fonctionnement, se traduit inéluctablement par une diminution constante de la taille de ses composants. La section et le pas des pistes métalliques qui interconnectent ces composants diminuent également, entraînant une augmentation du délai de propagation des signaux.

Les interconnexions sont classiquement réalisées par dépôt d'une couche conductrice, photolithographie puis gravure de la couche conductrice. Cette technique est largement utilisée dans le cas des circuits monocouches, avec des pistes métalliques en aluminium par exemple. Dans le cas des circuits multicouches, cette technique n'est pas adaptée et on lui préfèrera les procédés de métallisation « Damascène » qui consistent à graver un motif dans une couche diélectrique puis à le remplir par du métal. Ces procédés ont notamment permis l'utilisation du cuivre pour les interconnexions et ainsi, une diminution relative du délai de propagation.

Dans les circuits à plusieurs niveaux de métallisation, des trous, de facteur de forme élevé, sont réalisés dans les couches isolantes pour former des vias et ainsi relier les lignes d'interconnexion supérieure et inférieure. De manière classique, les ouvertures des vias peuvent être réalisées par gravure sèche, par plasma notamment, gravure humide ou ablation laser.

Dans le domaine de l'électronique organique, les motifs en matériau conducteur et les vias peuvent être réalisés par ces techniques de la microélectronique. Néanmoins, ces techniques sont coûteuses et leur compatibilité avec les matériaux organiques reste limitée. A titre d'exemple, l'enlèvement de la résine utilisée en photolithographie peut provoquer un décollement des couches en matériaux organiques. Par ailleurs, des problèmes de parallélisme et de verticalité des flancs des trous persistent avec ces techniques.

Le matériau diélectrique séparant les interconnexions en électronique souple est généralement organique et ne peut être gravé par les attaques chimiques dites « dures » utilisées traditionnellement en microélectronique. De nouvelles techniques, adaptées à l'électronique organique, ont donc été envisagées.

Le document US 6,403,397 décrit l'élimination de régions d'une couche formées sur des zones de relative faible adhérence par gommage ou immersion dans un solvant.

Une première méthode de formation de via est proposée par Kawase et al (« Inkjet Printed Via-Hole Interconnections and Resistors for All-Polymer Transistor Circuits », Adv. Mater. 2001, 13, No.21). Dans un premier temps, un matériau organique est déposé par voie liquide, par impression jet d'encre par exemple. L'ouverture correspondant au via est formée à travers le matériau organique par la projection contrôlée de gouttes de solvant. Le solvant est choisi de manière à dissoudre localement le matériau organique de la couche à graver. En éjectant les gouttes de solvant au même emplacement, un trou se forme progressivement, de même qu'un bourrelet à la périphérie du trou. Ce bourrelet est préjudiciable pour la qualité de l'empilement.

### Objet de l'invention

L'invention vise un procédé de formation de trous dans une couche, rapide, facile à mettre oeuvre et remédiant aux inconvénients de l'art antérieur.

Plus particulièrement, l'invention vise un procédé permettant la formation de trous avec un rapport de forme élevé et compatible avec les matériaux organiques.

Selon l'invention, on tend vers ces objectifs par le fait que le procédé comporte la prévision de première et seconde zones d'adhérence sur une surface d'un support. La première zone a des dimensions correspondant aux dimensions du trou. Le procédé comporte le dépôt d'une couche sur les première et seconde zones, le matériau de la couche présentant un coefficient d'adhérence sur la première zone inférieur au coefficient d'adhérence sur la seconde zone, et l'élimination de la partie de la couche disposée au-dessus de la première zone en balayant la surface de la couche avec un jet de fluide.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente une étape d'un procédé de formation de trous selon l'invention,
- la figure 2 représente une étape d'une variante de mise en oeuvre d'un procédé selon l'invention, correspondant à l'étape de la figure 1,
- les figures 3 à 5 représentent des étapes d'un procédé selon l'invention.

### Description de modes particuliers de réalisation

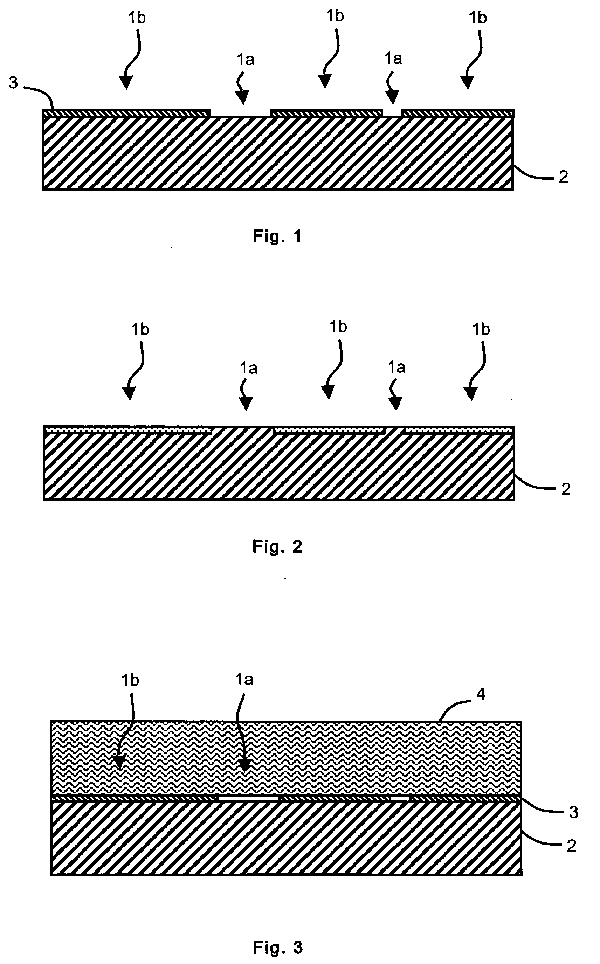

La figure 1 représente une première étape d'un procédé de formation de trous dans une couche en matériau diélectrique. Une première zone d'adhérence 1a et une seconde zone d'adhérence 1b sont formées sur une surface d'un support 2. Le support 2 peut être un substrat dont la surface comporte une pluralité de premières et secondes zones d'adhérence 1 a et 1 b. Sur l'exemple de la figure 1, le support 2 comporte deux zones d'adhérence 1 a et trois zones d'adhérence 1 b.

Le support 2 est, de préférence, un substrat souple. Le support 2 peut être en matière plastique, par exemple en polyéthylène naphtalate (PEN) ou en polyéthylène téréphtalate (PET). Le support 2 peut également être en silicium aminci, en métal comme l'inox ou l'acier flexible, ou en matière plastique recouvert de métal. Le métal utilisé pour recouvrir le substrat est, par exemple, l'aluminium ou l'or.

Les premières et secondes zones d'adhérence 1 a et 1 b sont formées, de préférence, par le dépôt localisé d'un agent d'adhérence sous la forme d'une couche mince. Cet agent d'adhérence est apte à se fixer sur la surface du support 2. Ainsi, une couche d'adhérence 3 est déposée sur des régions de la face supérieure du support 2 pour former les zones 1 a et 1 b. La couche 3 peut être déposée au niveau des premières zones 1 a ou au niveau des secondes zones 1 b. Sur l'exemple de la figure 1, la couche 3 forme les secondes zones d'adhérence 1 b et les régions de la surface du support 2 non recouvertes par la couche 3 forment les premières zones d'adhérence 1 a. Inversement, les premières zones 1 a peuvent être formées par le dépôt de la couche d'adhérence 3.

La couche d'adhérence 3 est, de préférence, une monocouche auto-assemblée SAM (« Self assembled monolayer » en anglais), elle-même pouvant être déposée sur une couche métallique. Les monocouches auto-assemblées comportent généralement des molécules bi-fonctionnelles, c'est-à-dire ayant deux groupements chimiques. Le premier, appelé groupement de tête, se fixe sur le support 2. Le second groupement, appelé groupement de queue, se lie étroitement avec un autre matériau. Ainsi, par l'intermédiaire de la couche SAM, on réalise l'accroche d'un matériau sur le support. La nature de la SAM est choisie en fonction de la nature du support 2 et du matériau que l'on souhaite faire adhérer. Par exemple, les groupements de tête thiol (S-H) se lient avec une surface d'or pour former une liaison thiolate (S-Au). Les SAM comprenant ce type de groupement sont, de préférence, utilisés avec des supports recouverts d'or. La couche d'adhérence 3 comporte, par exemple, une SAM de trimethylsilyl propanthiol et a une épaisseur inférieure à 10 nm. La couche d'adhérence 3 est déposée, de préférence, par impression jet d'encre. A l'inverse, la SAM peut diminuer l'adhérence du matériau sur le support, par exemple, avec des groupements de queue fluorés (le fluoropropanthiol notamment) pour former les premières zones de plus faible adhérence. Il existe d'autres SAM qui se lient directement aux supports en matière plastique, le triméthoxy-silane par exemple pour augmenter l'adhérence du matériau déposé sur le support, ou bien le fluoro-silane pour diminuer son adhérence.

La couche d'adhérence 3 peut également être une couche de métal. Dans le cas d'un support 2 en plastique recouvert de métal, la couche d'adhérence 3 métallique est choisie dans un matériau différent de celui recouvrant le support.

L'adhérence peut être modifiée par divers traitements de surface localisés, par exemple, par plasma, par exposition UV, par ozone, par laser...

La figure 2 représente une variante de réalisation de l'étape de formation des premières et secondes zones d'adhérence. La face supérieure du support 2 peut être texturée afin de modifier les paramètres de surface. Selon la forme de la structuration, la rugosité de certaines régions peut être diminuée ou augmentée, créant ainsi des zones d'adhésion plus ou moins élevée.

La figure 3 représente le dépôt d'une couche 4 en matériau diélectrique sur les premières et secondes zones d'adhérence 1 a et 1 b. Le coefficient d'adhérence du matériau diélectrique sur les premières zones 1 a est inférieur au coefficient d'adhérence sur les secondes zones 1 b. Dans le cas d'utilisation des SAM, le matériau diélectrique se lie étroitement avec les groupements de queue de la couche 3 au niveau des secondes zones d'adhérence 1 b, alors que le matériau diélectrique 4 adhère mal dans les premières zones 1 a non recouvertes par la couche 3. Le matériau diélectrique est, de préférence, déposé sur toute la surface du support par dépôt à la tournette (« spin coating », en anglais). L'épaisseur de la couche 4 en matériau diélectrique varie entre 500 nm et 10 µm. Le matériau diélectrique est, de préférence, un matériau organique. Ce matériau organique est, par exemple, choisi parmi la famille des styrènes (polystyrène), la famille des acrylates (polyméthylmétacrylate, PMMA), la famille des polyimides, le polyvinylcinnamate et le polyvinylpyrrolidane.

Chaque première zone d'adhérence 1 a est définie par rapport au trou que l'on souhaite former dans la couche diélectrique 4 précédemment déposée. Ainsi, les dimensions de la première zone correspondent aux dimensions du trou.

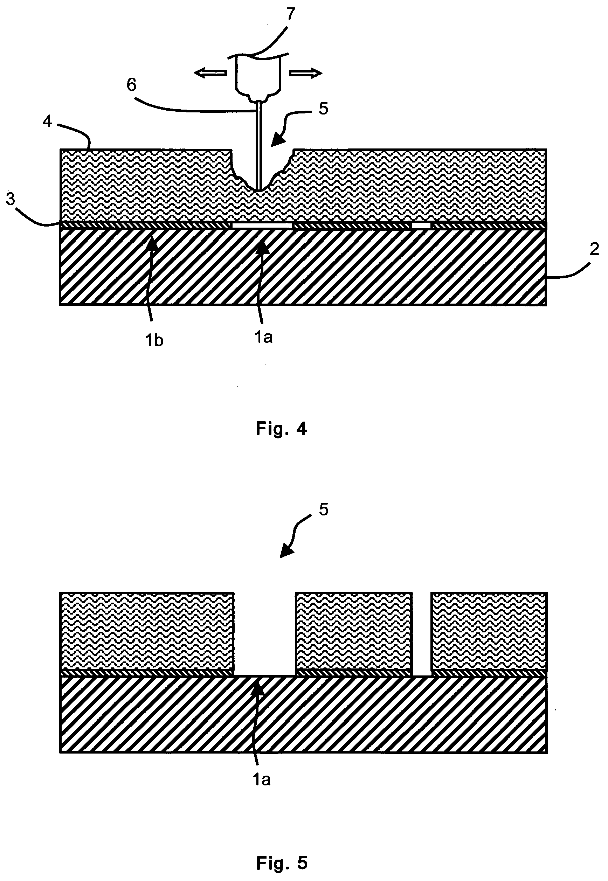

La figure 4 représente une étape d'élimination de la couche en matériau diélectrique 4 disposée au-dessus des premières zones 1 a pour former des trous 5. L'enlèvement du matériau diélectrique peut être réalisé par un jet de fluide 6. Le jet de fluide balaye la surface de la couche 4 et arrache préférentiellement le matériau diélectrique dans les zones n'ayant pas adhéré au support 2, c'est-à-dire au-dessus des premières zones d'adhérence 1 a.

Le jet de fluide 6 est dirigé, de préférence, sensiblement perpendiculairement à la face supérieure de la couche diélectrique 4. Il semblerait que l'arrachement local de matière soit favorisé par le fait que le jet induit, au niveau de ces zones, des vibrations d'énergie élevée provoquant une fatigue prématurée du matériau diélectrique.

La figure 5 représente la structure finale après l'étape d'élimination représentée à la figure 4. Chaque trou 5 formé est auto-aligné sur une première zone 1 a. A la figure 5, le trou 5 obtenu a des dimensions pouvant être comprises entre 100 nm et 1 µm en largeur (ou diamètre) et entre 500nm et 10 µm en hauteur. Le facteur de forme, c'est-à-dire le rapport hauteur sur largeur, peut dépasser deux, voire dix. Les bords des trous 5 restent nets.

Ainsi, le procédé décrit permet la formation de trous ayant un facteur de forme élevé. La résolution des motifs peut être augmentée en diminuant la largeur du jet de fluide 6, en changeant la buse 7 par exemple (figure 4). La résolution maximale est de l'ordre du micromètre. Le procédé est facilement reproductible et s'adapte à tous types de matériaux. Il évite ainsi l'utilisation de masques en verre dans le cas d'une réticulation aux ultraviolets et les problèmes de désalignement associés. Enfin, le développeur chimique traditionnellement utilisé en photolithographie est remplacé par un simple jet de fluide.

Dans le cas des circuits multicouches, le support 2 est remplacé par une couche inférieure de l'empilement. Le jet de fluide 6 ne détériore pas cette couche inférieure.

L'équipement employé pour l'étape d'élimination est classiquement utilisé en microélectronique pour le nettoyage de particules. Il comporte un support rotatif destiné à recevoir les substrats et un bras articulé (non représentés). Il comporte également une buse 7 d'un diamètre d'environ 30 µm. La buse 7 est alimentée par un fluide sous pression, de préférence de l'eau distillée. Le fluide sous pression peut également être un acide, une base, un solvant ou un gaz (azote, oxygène, argon).

Pour les besoins du procédé, les conditions de fonctionnement de cet équipement ont été adaptées. Ainsi, la buse 7 est disposée à une distance de l'ordre d'une dizaine de millimètres de la face supérieure de la couche diélectrique 4. La pression du fluide varie entre 100 bars et 200 bars. Le jet de fluide est avantageusement réduit pour percer des motifs plus fins. Ainsi, le débit pompé est moindre de même que la consommation en fluide.

Dans un mode de réalisation préféré, le matériau diélectrique est organique et réticulable. Le procédé comporte alors une étape de réticulation avant l'étape d'élimination du matériau diélectrique situé au-dessus des premières zones 1 a. Cette étape de réticulation de la couche 4 favorise la liaison entre le support 2 et la couche 4 par l'intermédiaire de la couche d'adhérence 3 et/ou accélère le phénomène de fatigue au niveau des zones qui n'adhèrent pas. En fonction du rapport des valeurs d'adhérence entre les deux surfaces, l'étape de réticulation peut être également réalisée après la gravure du trou. Le matériau diélectrique est, par exemple, un polymère réticulable aux ultraviolets comme le polyvinylcinnamate et le polyvinylpyrrolidane.

De nombreuses variantes et modifications du procédé décrit ici apparaîtront à l'homme du métier. Le procédé a été décrit pour la formation de vias dans un matériau diélectrique. Il n'est pas exclu d'utiliser cette technique pour des trous dans une couche en matériau quelconque pour d'autres applications.

## Revendications

1. Procédé de réalisation d'un trou (5) dans une couche (4), comportant les étapes suivantes :
- prévoir des première et seconde zones d'adhérence (1a, 1b) sur une surface d'un support (2), la première zone (1a) ayant des dimensions correspondant aux dimensions du trou (5),
- déposer la couche (4) sur les première et seconde zones, le matériau de la couche (4) présentant un coefficient d'adhérence sur la première zone (1a) inférieur au coefficient d'adhérence sur la seconde zone (1b),
**caractérisé en ce qu'**il comporte l'étape suivante:
- éliminer la partie de la couche disposée au-dessus de la première zone (1a) en balayant la surface de la couche avec un jet de fluide (6).

2. Procédé selon la revendication 1, **caractérisé en ce que** le matériau de la couche (4) est un matériau diélectrique.

3. Procédé selon l'une des revendications 1 et 2, **caractérisé en ce que**, le matériau de la couche (4) étant organique, il comporte, avant l'étape d'élimination, une étape de réticulation du matériau de la couche.

4. Procédé selon la revendication 3, **caractérisé en ce que** le matériau de la couche (4) est réticulable aux ultraviolets.

5. Procédé selon l'une quelconque des revendications 1 à 4, **caractérisé en ce que** les première et seconde zones d'adhérence (1a, 1b) sont formées par dépôt localisé d'une couche d'adhérence (3).

6. Procédé selon la revendication 5, **caractérisé en ce que** la couche d'adhérence (3) est une monocouche auto-assemblée (SAM).

7. Procédé selon la revendication 5, **caractérisé en ce que** la couche d'adhérence (3) est une couche de métal.

## Patentansprüche

1. Verfahren zur Herstellung eines Lochs (5) in einer Schicht (4), das die folgenden Schritte umfasst:
- Vorsehen eines ersten und eines zweiten Haftbefeichs (1a, 1b) auf einer Oberfläche eines Substrats (2), wobei der erste Bereich (1a) Abmessungen aufweist, die den Abmessungen des Lochs (5) entsprechen,
- Abscheiden der Schicht (4) auf dem ersten und dem zweiten Bereich, wobei das Material der Schicht (4) eine Haftreibungszahl auf dem ersten Bereich (1a) aufweist, die niedriger als die Haftreibungszahl auf dem zweiten Bereich (1b) ist,
dadurch gekenntzeichnet, dass es den folgenden Schritt umfasst:
- Entfernen des oberhalb des ersten Bereichs (1a) angeordneten Teils der Schicht durch Bestreichen der Oberfläche der Schicht mit einem Fluidstrahl (6).

2. Verfahren nach Anspruch 1, **dadurch gekennzeichnet, dass** das Material der Schicht (4) ein dielektrisches Material ist.

3. Verfahren nach einem der Ansprüche 1 und 2, dadurch gekenntzeichnet, dass es, wenn das Material der Schicht (4) organisch ist, vor dem Entfernungsschritt einen Schritt zum Vernetzen des Materials der Schicht umfasst.

4. Verfahren nach Anspruch 3, **dadurch gekennzeichnet, dass** das Material der Schicht (4) UV-vernetzbar ist.

5. Verfahren nach einem der Ansprüche 1 bis 4, dadurch gekennzeichet, dass der erste und der zweite Haftbereich (1a, 1b) durch stellenweises Abscheiden einer Haftschicht (3) gebildet sind.

6. Verfahren nach Anspruch 5, **dadurch gekennzeichnet, dass** die Haftschicht (3) eine selbstorganisierende Monoschicht (SAM) ist.

7. Verfahren nach Anspruch 5, dadurch gekenntzeichnet, dass die Haftschicht (3) eine Metallschicht ist

## Claims

1. Method for making a hole (5) into a layer (4), comprising
- providing first and second adhesion areas (1a, 1b) on a surface of a support (2), the first area (1a) having dimensions corresponding to the dimensions of the hole (5),
- depositing the layer (4) on the first and second areas, the material of the layer (4) having an adhesion coefficient to the first area (1a) lower than the adhesion coefficient to the second area (1 b),
**characterized in that** it comprises the following step:
- eliminating the part of the layer on the first area (1a) by scanning the surface of the layer with a jet fluid (6).

2. Method according to claim 1, **characterized in that** the material of the layer (4) is a dielectric material.

3. Method according to any one of claims 1 or 2, **characterized in that**, the material of the layer (4) being organic, it comprises, before the elimination step, a step of curing the material of the layer.

4. Method according to claim 3, **characterized in that** the material of the layer (4) is cross-linkable under ultraviolet rays.

5. Method according to any one of claims 1 to 4, **characterized in that** the first and second adhesion areas (1a, 9b) are formed by a localized deposition of an adhesion layer (3).

6. Method according to claim 5, **characterized in that** the adhesion layer (3) is a self-assembled monolayer (SAM).

7. Method according to claim 5, **characterized in that** the adhesion layer (3) is a metal layer.
